# EUROPEAN PATENT APPLICATION

(11) **EP 4 391 008 A1**
(43) Date of publication of application: **26.06.2024**
(21) Application number: 23218498.6
(22) Date of filing: 20.12.2023
(51) Int. Cl.: H01J 37/143, H01J 37/145

(54) **ADJUSTABLE MAGNETIC LENS HAVING PERMANENT-MAGNETIC AND ELECTROMAGNETIC COMPONENTS**

(30) Priority: 22.12.2022 EP 22216094
(71) Applicant: IMS Nanofabrication GmbH, 2345 Brunn am Gebirge (AT)
(72) Inventor: Spengler, Christoph, 1150 Wien (AT); Leitner, Johannes, 1120 Vienna (AT); Puchberger, Dietmar, 1170 Vienna (AT); Moser, Daniel, 1150 Vienna (AT)
(74) Representative: Patentanwaltskanzlei Matschnig & Forsthuber OG

(57) **Abstract**

A fine-adjustable charged particle lens (10) comprises a magnetic circuit assembly (20) including permanent magnets (21) and a yoke body (25), surrounding a beam passage (11) extending along the longitudinal axis (cx). The permanent magnet is arranged between an inner yoke component (250) and an outer yoke component (251) so as to form a magnetic circuit having at least two gaps (290, 291), generating a magnetic field (61) reaching inwards into the beam passage, into which a sleeve insert (50) having electrostatic electrodes can be inserted, which may also generate an electric field (65) spatially overlapping said magnetic field. An electromagnetic adjustment coil (31) is located between the inner and outer yoke shell (250, 251). This electromagnetic adjustment coil (31) is driven by an adjustable supply current running primarily along a circumferential direction and modifies the magnetic flux in the magnetic circuit to cause a variation in the magnetic flux density in the gaps (290, 291).

## Description

### Field of the invention and description of prior art

The present invention relates to a charged particle lens comprising a permanent magnet configured to modify a charged particle beam of a charged particle optical apparatus, which is designed to be used for lithography writing and like processing purposes, including nano-patterning. Such a lens is provided with a passage for a charged particle beam along a longitudinal direction, which corresponds to the direction of propagation of the charged particle beam itself, and will usually be aligned concentrically with the optical axis of the charged particle optical apparatus it is used in.

The invention also relates to an electromagnetic lens including a charged particle magnetic lens, as well as a charged particle optical apparatus including a lens of the mentioned type.

The applicant has realized charged particle multi-beam apparatuses, which can incorporate one or more lenses of the mentioned type, and has developed the corresponding charged particle optical components, pattern definition devices, and writing methods, suitable for multiple charged particle beams at once; they have commercialized thereof a 50 keV electron multi-beam writer called eMET (electron Mask Exposure Tool) or MBMW (multi-beam mask writer), which is used to realize arbitrary photomasks for 193nm immersion lithography, as well as masks for EUV lithography and templates for nanoimprint lithography. The applicants system has also been called PML2 (Projection Mask-Less Lithography), used for electron beam direct writer (EBDW) applications directly on substrates.

For increasing throughput in high-volume industrial manufacturing, with particular regard for mask-less lithography and direct-writing on substrates (e.g. wafers), there is the need to increase the electrical current carried by the charged particle beam passing through the charged particle nano-pattering apparatus; this is usually at the cost of limiting the resolution due to Coulombic interactions between the charged particles and will require a corresponding compensation by reduction of the magnitude of the optical aberrations introduced by the apparatus through other mechanisms. To this end, the applicant has developed a charged particle multi-beam apparatus consisting of multiple parallel optical columns combined in a multi-column fashion, each column having a reduced ("slim") cross-section diameter, as compared to earlier writer setups such as eMET.

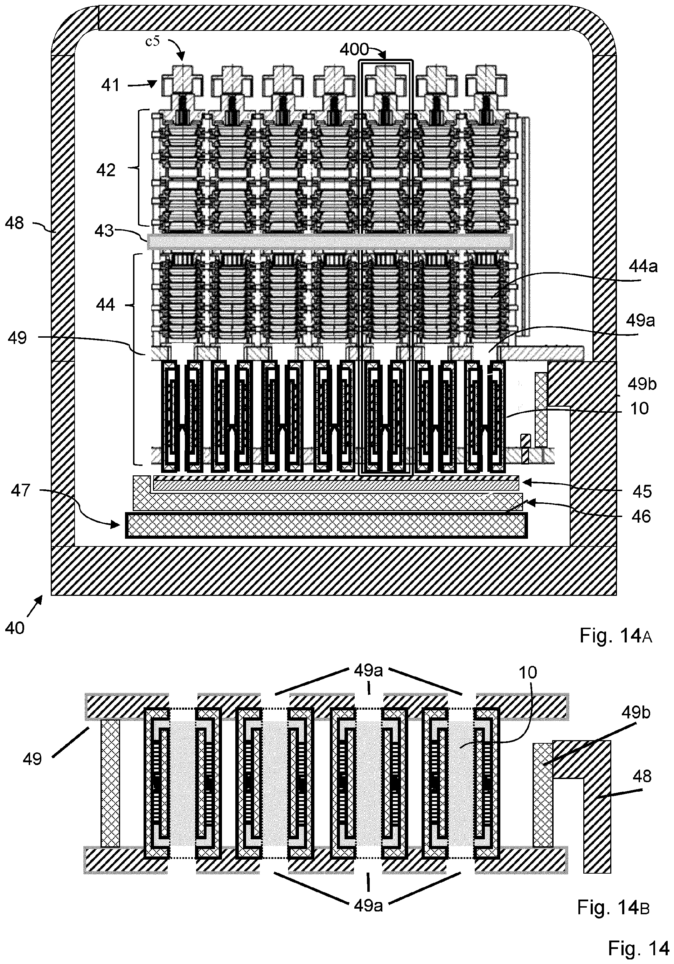

Such a multi-column apparatus (one embodiment is discussed below referring to Fig. 14) enables significantly larger electrical currents with the charged particle beams, while overcoming the limitations due to the trade-off between electrical current and optical aberrations found in single-column systems. This is due to the fact that the total current delivered to the target is split into multiple optical axes, while the resolution limitation is dominated by the amount of current per axis. Single columns of this type are well known in prior art, such as US 6,768,125, EP 2 187 427 A1 (= US 8,222,621) and EP 2 363 875 A1 (= US 8,378,320) of the applicant.

A typical multi-column system includes multiple optical sub-columns, each of which comprises an illuminating system that delivers a broad telecentric charged particle beam to a pattern definition system followed by a charged particle projection optics, which for example includes a multitude of electrostatic, magnetic, and/or electromagnetic lenses.

For using such a system as a high-throughput wafer-direct-writer it will be necessary to place a substantial number of columns above one semiconductor wafer, e.g. in the order of one hundred columns. However, this setup limits the radial dimension of each column to a diameter of just a fraction of the width of the full wafer; for instance in the case of a typical 300 mm (12") wafer, a diameter of roughly 30mm may be used. Slim-diameter magnetic lenses, on the other hand, cannot be realized by coil-based magnetic lenses, because reduction of the column diameter would correspond to extremely large Joule heating due to the large electrical currents needed to operate the coils to generate sufficiently strong magnetic fields; however, there is insufficient space for an adequate temperature-control system, including high-precision sensors and isotropic and homogeneous cooling, which would be required for conventional coil-based magnetic lenses.

The mentioned limitations driven by heat-related and geometrical requirements are severe, but can be overcome by employing magnetic lenses based on permanent magnets together with a magnetic permeable yoke body for directing the magnetic flux and thus generating a magnetic field, such as the possible embodiments of the present invention. However, such permanent magnets cannot be tuned much after completion of manufacturing and assembly, therefore their applications in magnetic lenses are limited. This represents a serious disadvantage with respect to coil-based magnetic lenses, whose magnetic field can be controlled by adjusting the electrical current passing through the coils. Especially given inherent limitations on the precision of the targeted magnetic field due to manufacturing and assembly, accuracies of magnet manufacturers are vital for operational purposes of a magnetic lens comprising such magnets; current precision limitations correspond to a deviation of approximately 1% - 5% to the targeted magnetic field; the strength of the magnetic field is in the order of 1 T.

The mentioned deviations are due to tolerances and statistical uncertainties of manufacturing, which are virtually unavoidable for a manufacturing process having a reasonable yield of magnetic lenses for high-volume production. The present invention offers a new approach for compensating these deviations, by including additional components that allow tuning the magnetic field during initialization and/or operation of the lenses. The invention removes the burden of (unrealistic) precision in manufacturing permanent magnets for the use in magnetic lenses, and in effect increases the usage spectrum of permanent magnetic materials usable for high-precision systems, as the applicants invention is able to compensate deviations of an actual permanent magnet from a desired nominal magnetic field strength, and can even allow higher deviations, as long as geometrical parameters of the system are still within specifications.

In-situ, i.e. during operation of said apparatus, tuning of charged particle lenses based on permanent magnets is typically done by deploying them in combination with one or more additional electric lenses; i.e. forming a charged particle electromagnetic lens, such as magnetic lenses based on permanent magnets together with electrostatic elements for fine-adjustment. US 9,165,745 discloses a permanent-magnet-based electromagnetic lens combined with a coil-based magnetic lens for fine adjustment, which can tune the magnetic field, but has at least the above-mentioned heating and geometrical problems. Furthermore, the magnetic field of the above state-of-the-art magnetic lenses is insufficiently confined to the space of the charged particle lens itself, causing severe cross-effects in the case of a large number of lenses arranged side by side in a multi-column system.

### Summary of the invention

In view of the above, it is an object of the present invention to provide a charged particle lens which includes permanent magnets, but allows for adjusting the optical properties of the lens with high precision. At the same time, it is desired to increase the range of permanent magnets that can be employed in this lens setup. Furthermore, lenses of this invention are of slim shape and enable confinement of the magnetic and electric fields within a close vicinity of the lens itself; thus enabling multi-column optics of reduced cross-talk.

The above object is met by a lens configured to modify (e.g. shape, focus/defocus or otherwise manipulate) a charged particle beam of a charged particle optical apparatus, the lens being provided with a passage space, also referred to as beam passage, which extends primarily along a longitudinal axis and allows the passage of said charged particle beam, wherein further the lens includes a magnetic circuit assembly, which comprises at least one permanent magnet and a yoke body composed of at least two components of high magnetic permeability, and further includes an electromagnetic adjustment coil located in the yoke body.

The yoke body includes a first yoke component which can be realizing an inner yoke shell, arranged surrounding the passage space, and a second yoke component which can be realizing an outer yoke shell, arranged surrounding the inner yoke shell (herein the terms "inner" and "outer" refer with respect to their relative position within the lens assembly and central axis); these yoke components are arranged circumferential around the longitudinal axis and are suitably made of magnetic highly permeable materials such as ferromagnetic or ferromagnetic materials.

The at least one permanent magnet is arranged between the at least two yoke components, i.e. around the inner yoke shell and within the outer yoke shell, and comprises a permanent magnetic material that is magnetically mainly oriented with its two magnetic poles towards respective yoke components.

The permanent magnet and the yoke body form a closed magnetic circuit, but for having at least two gaps formed between respective faces of different yoke components opening at the beam passage (for instance located at each axial ends, between faces of the inner yoke shell towards a respectively corresponding face of the outer yoke shell); thus, the magnetic circuit directs a magnetic flux effected by the permanent magnets through the yoke body and induces a magnetic field in the gaps, which also reaches into the beam passage. It is this magnetic field from the gaps that is used to form a magnetic lens for the charged particle beam propagating in the beam passage along the longitudinal axis. Manufacturing of said magnetic lenses can typically reach magnetic field accuracies within a range of 1% - 5% around the targeted value. The electromagnetic adjustment coil, which is preferably located between the inner and outer yoke shell, is configured to be driven by an adjustable supply current; this electric current in the electromagnetic adjustment coil is substantially running along a circumferential direction around the longitudinal axis, and the electromagnetic adjustment coil is configured to modify the magnetic flux in the magnetic circuit to cause a variation in the magnetic flux density in at least one of the gaps, which is used to form magnetic lenses inside the beam passage to act upon the particle beam passing therethrough. Thus, the invention allows for improved control of the properties of the particle lens at a better accuracy. Accuracies of such lenses can, by virtue of modulating the magnetic field in the gaps as mentioned, be within a range of 0.1% - 0.5% (or even better) to a desired value of magnetic fields or even lower values, which therefore yields magnetic lens manufacturing with roughly an order of magnitude more efficiency, i.e. closer to designed optical properties, e.g. focal length; compared to the performance of the same magnetic lenses without such adjustment coil. The invention also allows for controlling, such as modulating or stabilizing, the properties of the magnetic circuit during operation, depending on the actual situation.

In the technical solution underlying the invention, the yoke components and the at least one permanent magnet together form a closed magnetic circuit with two gaps, but optionally also more than two gaps, which are located next to the beam passage; since these gaps serve to induce a defined magnetic flux density and thus magnetic field reaching into the beam passage, acting as a magnetic lens. The electromagnetic adjustment coils of the invention may also be used to compensate deviations of the magnetic field from a nominal value. An electromagnetic adjustment coil of the invention is positioned at a location which is suitable for affecting the magnetic flux in a suitable manner. It may also be used to introduce and/or tune asymmetries of the magnet circuit assembly. As a consequence, the invention allows reducing or even eliminate deviations in strength and partially also direction from desired nominal values, so as to reach its specified properties according to initial design, which otherwise might not be met with the manufacturing process of the permanent magnet and its immanent tolerances.

The invention allows the use of permanent magnets as presently manufactured, which can be assembled into a charged particle lens, by adjusting the magnetic flux using an electromagnetic adjustment coil of the invention. Thus, the magnetic field defining the lens effect at the locations of the gaps can be fine-tuned. Therefore, the invention allows to account for limited accuracies of manufacturing of permanent magnet materials and components and distinctly helps to limit effects thereof. It also incorporates reduction of stray magnetic fields.

Additionally, within the invention several optional developments are envisaged, which can be combined wherever suitable, as follows:
In one advantageous development of the invention also an electromagnetic sectorial adjustment coil arrangement may be provided, which comprises two or more sector coil elements, wherein each sector coil element is realized with a general winding axis pointing in a respective radial direction. The sector coils of the sectorial adjustment coil are preferably arranged in mutual circumferential angular offsets around the longitudinal axis, and are preferably configured to act at least partially like a magnetic multipole.

Furthermore, the electromagnetic adjustment coil, and optionally the sectorial adjustment coil arrangement, may suitably be configured to induce a redistribution of magnetic flux between two or more branches of the magnetic circuit, resulting in a change of the magnetic flux density in the at least two gaps. This will be advantageous in order to, e.g., reduce or increase the difference in focal length of the two lenses. In combination thereto, or alternatively, the electromagnetic adjustment coil, and optionally the sectorial adjustment coil arrangement, may suitably be configured to induce a modification of magnetic flux affecting mainly one of two or more branches of the magnetic circuit, resulting in a change of the magnetic flux density in a corresponding gap. With this, the single lenses can be fine-tuned with high precision to the needs of the optical system.

Also it will often be of advantage to provide two or more electromagnetic adjustment coils, which then are located at different locations associated with different components of the magnetic circuit assembly, configured to adjust the magnetic field in the two gaps differently. Here and in the following the electromagnetic adjustment coil may also include, or be realized as, sectorial adjustment coil arrangements as is deemed suitable in the respective embodiment.

Furthermore, one yoke component may realize a housing body of the lens which surrounds the other parts of the magnetic circuit, and in particular other yoke components, also the permanent magnet(s) and electromagnetic adjustment coil(s). Generally, some parts of the magnetic circuit may be used for realizing a housing of the lens, and the at least one permanent magnet and/or the at least one electromagnetic adjustment coil, all arranged around the inner yoke shell, and/or all yoke components could also be part of the housing body of the lens. The lens design may, preferably, have an overall rotationally symmetric shape with respect to the longitudinal axis, wherein the components of the magnetic circuit assembly, i.e. in particular the permanent magnet(s), the yoke body, as well as the electromagnetic adjustment coil, are arranged coaxial with the longitudinal axis and preferably have basic shapes corresponding to hollow cylinders or hollow polygonal prismatic shapes.

For supporting the electromagnetic adjustment coil(s) at its/their respective defined positions, suitable holders may be provided within the yoke body. In particular, a holder component configured to keep the adjustment coil(s) in a respective defined position between the at least two components of the yoke body may be provided, which may be configured to precisely define the relative influence on respective components of the magnetic circuit assembly.

Advantageously the adjustment coil(s) of the invention may be provided with an electrical interface to the outside of the charged particle lens, configured to supply the coil(s) with electrical current, the electric interface preferably including a passageway such as suitable holes formed in the outer yoke shell.

Furthermore, two or more electromagnetic adjustment coils may be provided, which are located at different locations associated with different components of the magnetic circuit or magnetic circuit assembly. This may be used to fine-tune the single lenses separately and precisely.

Furthermore, the permanent magnets and/or the electromagnetic adjustment coil(s) and/or component(s) thereof may by composite, for instance composed of one or more sectors arranged around the longitudinal axis and/or segmented into two or more layers stacked along the longitudinal axis. Said sub-components (sectors, segments and/or layers) can also be made of varying materials having different magnetic properties (magnetic permeability, geometric dimensions) to form local gradients of the flux reduction. Thus, an adjustment coil of the invention may comprise two or more sub-elements, preferably shaped as sectors of an annular shaped element. This may be configured to create an azimuthal magnetic gradient for enabling the magnetic lens to have azimuthal differentially varying magnetic flux densities and thus azimuthal varying magnetic fields around the longitudinal axis. Thus, the composite coil element may act at least partially like a magnetic multipole. These sub-elements may, moreover, be provided with individual electrical interfaces to the outside of the charged particle lens, configured to supply respective electric currents, for instance through suitable holes formed in the outer yoke shell.

In many typical embodiments the permanent magnet(s) may have magnetization oriented substantially radially. Herein, the expression "substantially radial" is used to include the case that the orientation is "operationally radial" such that the magnetic flux through the permanent magnet or electromagnetic element to yoke components flows along a generally radial direction (flowing from a relative inner yoke component to a relative outer yoke component or vice versa)

In an advantageous development the permanent magnet(s) may also be composed of two or more layers stacked along the longitudinal axis; furthermore, it may be suitable to realize the permanent magnet(s) composed of three or more sectors arranged around the longitudinal axis along a circumferential direction, where preferably the magnet sectors are substantially wedge-shaped elements forming sectors with respect to the longitudinal axis.

A further aspect of the invention relates to an electromagnetic lens which includes the charged particle lens according to the invention and a sleeve insert inserted into the beam passage along the longitudinal axis, with the sleeve insert surrounding a smaller portion of the beam passage opening, but extending between both ends thereof along the longitudinal axis; preferably at least overlapping the gaps of the yoke components. This sleeve insert comprises one or more electrically conductive electrode elements, to which a respective electric potential can be applied using power supplies so as to generate an electric field within its beam passage. Advantageously the electrode elements may be configured to form a particle optical lens in conjunction with the magnetic field within the passage opening at the gap(s), wherein optical parameters, e.g. focal length, of said particle optical lens are adjustable even further through modifying the electric potentials applied to the electrode elements.

According to a suitable geometric layout the yoke body may extend between and thus form the two axial ends of said beam passage; in particular the first component, e.g. inner yoke shell, may extend from the beginning to the end of a central portion of the passage, but keeping said gaps open at either ends towards the second component, e.g. the outer yoke shell, which surrounds the inner yoke shell radially and axially, preferably extending to either sides thereof; the yoke components may thus form a geometry of two hollow cylinders, concentrically nested. Thus, the inner yoke shell surrounds at least parts of the sleeve insert; the gaps of the magnetic circuit respectively induce a magnetic field which, reaching inwards into the passage opening, shall overlap with the electric fields generated by electrode elements of the sleeve insert, which allows to establish an electromagnetic lens. Such electromagnetic ultra-fine-tuned lenses can enhance the precision down to 1ppm - 5ppm accuracy range with respect to the designed properties. For instance, the focal length of such electromagnetic lens(es) is adjustable during operation, i.e. during times when a charged particle beam is passing through, by modifying the electric potentials applied to the electrode elements.

In many embodiments, the sleeve insert may also comprise a ceramic body on which the electrode elements are realized as conductive coatings of respectively limited shape and area.

Electrode elements may often be configured (mechanically and electrically) to form at least one Einzel lens; furthermore, in many embodiments of the invention, at least one of the electrode elements may include an electrostatic multipole electrode comprising a number of sub-electrodes arranged uniformly around the longitudinal axis along a circumferential direction, enabling the lens to deflect or shape the charged particle beam traversing said electrode elements, where the electric potential applied to the sub-electrodes of this element may be defined to form electrical multipole fields.

In many embodiments of the lens of the invention, in particular in those cases where the lens is intended to be used in connection with a pattern definition system (PD), among the electrode elements may be a beam aperture element forming a delimiting opening with a defined radius around the longitudinal axis, the delimiting opening limiting the lateral width of a charged-particle beam propagating through the passage. This delimiting opening may be used as a calibration aperture, enabled for collecting particles, including those intentionally deflected in a pattern definition system; meant to prevent particles from reaching the target of the charged particle beam. Furthermore, for example the beam aperture element may be connected to a current measurement device, which may be used to measure the amount of the charged particles absorbed at the beam aperture element. In front, i.e. upstream, of such a beam aperture element, it is advantageous to have an electrostatic multipole electrode, configured to determine a transversal position of the beam with respect to the longitudinal axis, by applying different suitable electrostatic potentials to the sub-electrodes and thus scanning the beam across the aperture.

Preferably the charged particle lens may have an overall rotationally symmetric shape along said longitudinal axis, wherein the components of the magnetic circuit assembly are arranged coaxial with said longitudinal axis and preferably have basic shapes corresponding to hollow cylinders or hollow polygonal prismatic shapes.

In contrast to known magnetic lenses such as shown in US 9,165,745, the electromagnetic lens of the invention has a magnetic loop which is completely closed except only for a number of "air gaps" in the housing body, which allow to deploy the magnetic field at desired regions of the optical axis, thus having diminished influence due to stray fields (existing in single gap systems according to Ampere's circuit law) acting negatively on the performance of the electromagnetic lens as employed in charged particle multi-beam nano-patterning apparatuses. Thus, in order to minimize stray fields present in the above mentioned state-of-the-art systems it is highly advantageous to provide (at least) two gaps. However, it will be clear that the number of gaps may be higher, such as three or four or more, depending on the individual application of the lens.

For at least the above reasons, the present invention and its application in writer tools such as multi-column multi-beam charged particle nano-patterning systems (e.g. for direct writing of substrates), offer a unique combination of magnetic, electrical and calibration components, which is expected to significantly impact the development of high-throughput industrial processes for integrated circuits. This invention significantly facilitates layout, construction, fine- and even ultra-fine-adjustments for controlling of writer tools, and in particular of a multi-column multi-beam mask-writers too.

A further aspect of the invention is directed at a charged particle optical apparatus including a charged particle lens according to the invention (including an electromagnetic lens according to the invention) and configured for influencing a charged particle beam of said apparatus propagating through the lens along the optical axis thereof, wherein said lens is part of an particle optical system of said apparatus suitable for magnetic lenses. In particular, the apparatus may preferably be realized as a multi-column system comprising a plurality of charged particle optical-columns, each column using a respective particle beam and comprising a respective optical system which includes a respective lens of the invention.

### Brief description of the drawings

In the following, in order to further demonstrate the present invention, illustrative and non-restrictive embodiments are discussed, as shown in the drawings, which show schematically:

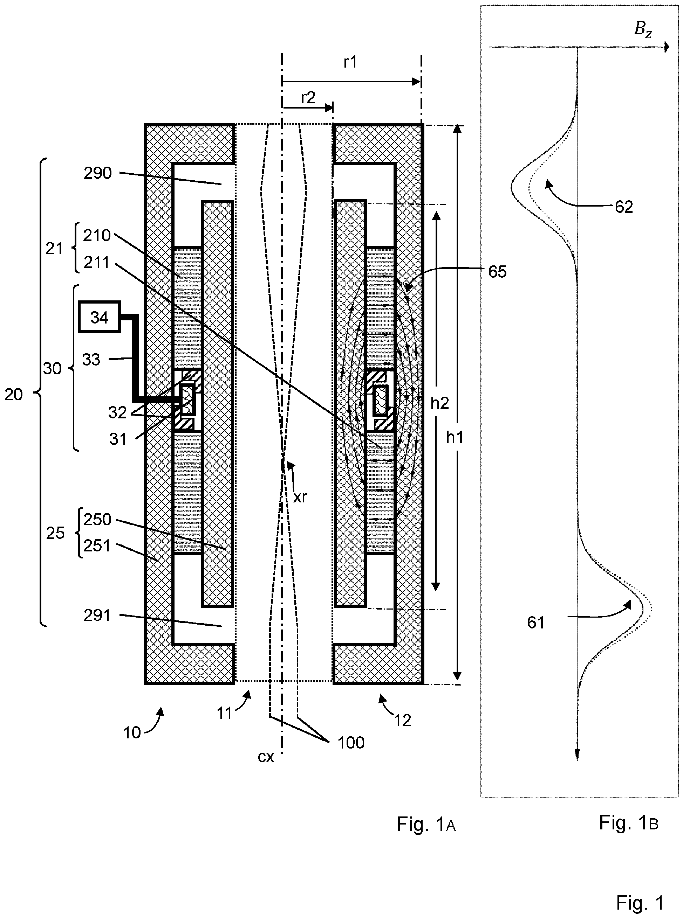

- Fig. 1: illustrates a charged particle lens according to a first embodiment of the invention, where Fig. 1_{A} (to the left of the drawing) is a longitudinal sectional view of the charged particle lens including an electromagnetic adjustment coil according to the invention, located at an "equatorial" position within the magnetic circuit; and Fig. 1_{B} is a plot of the strength of the axial component of the magnetic field, with an electromagnetic adjustment coil (dashed line) and without it (solid line), measured at the location of the central axis as a function of the longitudinal coordinate of Fig. 1A;
- Fig. 2: shows an embodiment of an electromagnetic adjustment coil of symmetric ring shape configured for controlling a magnetic lens of Fig. 1A; Fig. 2A shows a cut-open view of the element, while Fig. 2_{B} shows a cross-section;
- Fig. 3: shows an embodiment of a sectorial electromagnetic adjustment coil in a top view;
- Fig. 4: shows a perspective view of two component coils of a four-sector arrangement of a sectorial coil arrangement;
- Fig. 5: shows a top view of the four-sector arrangement of a sectorial coil arrangement;
- Fig. 6: illustrates a charged particle lens according to another embodiment of the invention, which has an adjustment coil asymmetrically placed with respect to the longitudinal coordinate of the lens, where Fig. 6_{A} (to the left of the drawing) is a longitudinal sectional view of the charged particle lens; and Fig. 6_{B} is a plot of the strength of the axial component of the magnetic field without an asymmetric adjustment coil (dashed line) and with it (dotted line), measured at the location of the central axis as a function of the longitudinal coordinate of Fig. 6A;
- Fig. 7: shows an embodiment of a permanent magnet composed of ring elements having radial magnetization, in a perspective view (Fig. 7_{A}), and a longitudinal section (Fig. 7_{B});
- Fig. 8: illustrates several embodiments of permanent magnets in respective cross-sectional views, some of which are sectorized (Figs. 8_{B} to Fig. 8D) and in variations of preferable magnetizations;

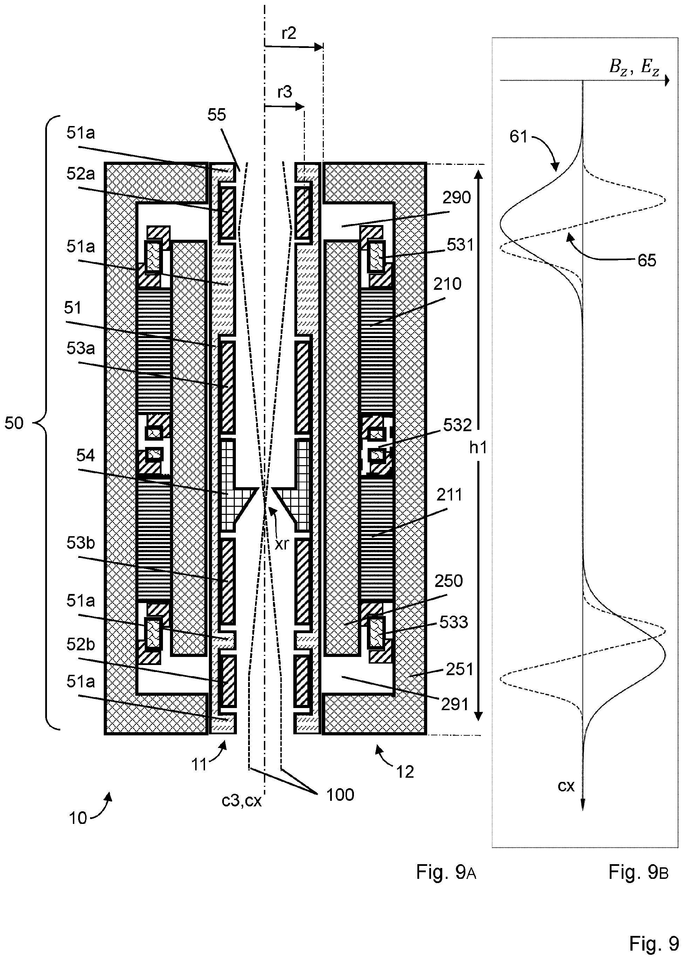

- Fig. 9: illustrates a charged particle lens according to a further embodiment of the invention including a sleeve insert, which also includes multiple instances of the electromagnetic adjustment coil of the invention, where Fig. 9_{A} (to the left of the drawing) is a longitudinal sectional view of the charged particle lens and the electrical sleeve insert therein, forming an electrostatic lens system; and Fig. 9_{B} is a plot of the strength of the axial component of the magnetic field (solid line) of said magnetic lens and the electric field (dashed line), measured at the location of the central axis as a function of the longitudinal coordinate of Fig. 9A;
- Fig. 10: is a schematic overview of the electric voltage supplies connected to the sleeve insert and its elements in one embodiment of the lens of Fig. 9A;
- Fig. 11: shows a cross-sectional view of a multipole electrode having eight sub-electrodes;
- Fig. 12: shows an enlarged detail of the calibration aperture and a preceding multipole as components of a sleeve insert of an electromagnetic lens of one embodiment of this invention;
- Fig. 13: is a longitudinal sectional view of a slim-column writer tool incorporating a charged particle lens of the invention;
- Fig. 14: illustrates a multi-column writer tool incorporating a plurality of instances of the lens of the invention, where Fig. 14_{A} is a longitudinal sectional view of the multi-column writer tool; and Fig. 14_{B} is a detail view of the portion comprising said lenses and including an embodiment of a multi-lens holder device.

### Detailed description of embodiments of the invention

The detailed discussion of exemplary embodiments of the invention given below discloses the basic ideas, implementation, and further advantageous developments of the invention. It will be evident to the person skilled in the art to freely combine several or all of the embodiments discussed here as deemed suitable for a specific application of the invention. Throughout this disclosure, terms like "advantageous", "exemplary", "typical", "preferably" or "preferred" indicate elements or dimensions which are particularly suitable -but not essential- to the invention or an embodiment thereof, and may be modified wherever deemed suitable by the skilled person, except where expressly required. It will be appreciated that the invention is not restricted to the exemplary embodiments discussed in the following, which are given for illustrative purpose and merely present suitable implementations of the invention. Within this disclosure, terms relating to a vertical direction, such as "upper" or "down", are to be understood with regard to the direction of the particle-beam traversing the electromagnetic lens, which is thought to run downwards ("vertically") along a central axis (or longitudinal axis). This longitudinal axis is generally identified with the Z direction, to which the X and Y directions are transversal.

### Charged Particle Lens

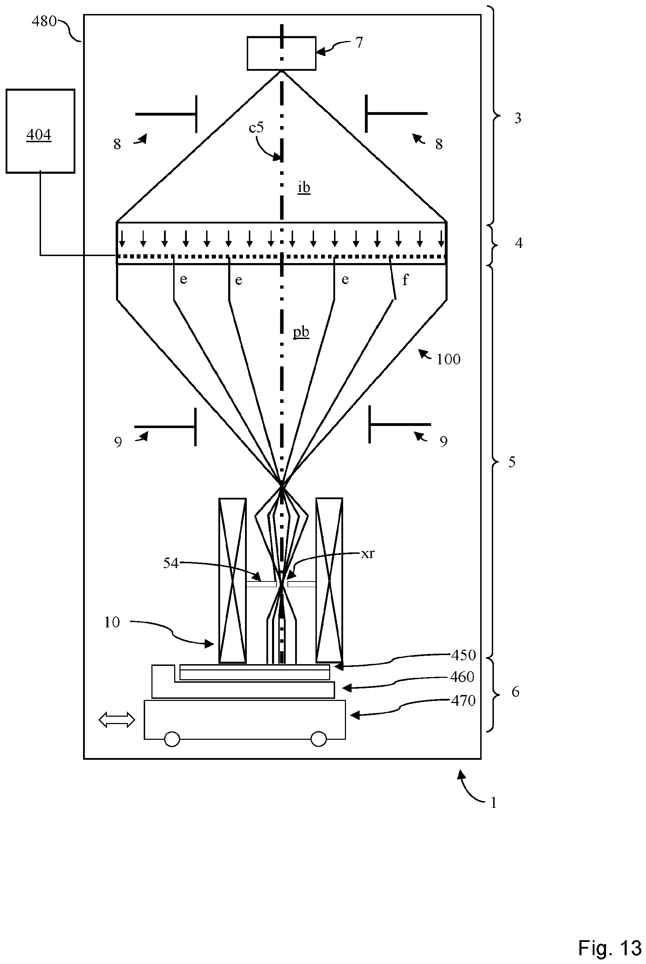

Fig. 1A depicts an charged particle lens 10 according to a first embodiment of the invention, in a longitudinal sectional view, i.e. along a section plane passing through its central axis cx. For the sake of better clarity, the components are not shown to size. The lens may be used to implement a lens 10 of the writer tool 1 of Fig. 13 or multi-column writer tool 40 of Fig. 14 (see below), where it is used as an objective lens, but it will be appreciated that it is suitable for use in many other particle optical devices which may implement a single-column or multi-column architecture, e.g. as disclosed in US 9,443,699 and US 9,495,499 of the applicant, and the disclosure of those documents are herewith included by reference into the present disclosure.

The charged particle lens 10 includes a beam passage 11 for a charged particle beam 100 traversing the assembly, a magnetic circuit assembly 20, which comprises at least one permanent magnet 210, 211, and a yoke body 25 with at least two gaps 290, 291, and an electromagnetic adjustment assembly 30 according to the invention. The mentioned magnets are made of a permanent magnetic material, typically with a remanence of about 1 T and a magnetic flux, symbolically denoted as Φ₀; the yoke body 25 comprises two yoke components 250, 251, of which the outer yoke shell 251 also serves a housing body 12 for the lens, and are made of a high magnetically permeable material; the yoke components form at least two gaps 290, 291 at two different axial positions, at which the magnetic flux streaming through the circuit assembly will induce a magnetic field reaching into the beam passage 11. Furthermore, the electromagnetic adjustment assembly 30 comprises at least one electromagnetic adjustment coil 31, placed between the two yoke components 250, 251 in a suitable position, and powered by an electric current source 34 to generate a magnetic field, forming an additional magnetic contribution fed to the magnetic circuit assembly. By means of this magnetic field the electromagnetic adjustment assembly 30 enables to adjust the magnetic field in at least one of the two gaps 290, 291.

Depending on the strength of magnetic lensing effect the charged particle beam 100 may also form a cross over xr in said beam passage 11, i.e. the beam reaching a minimal lateral width while crossing the central axis cx; the dotted lines symbolize an envelope of a charged particle beam as it propagates through the lens if deployed in an exemplary particle beam exposure system (such as the writer tool 1 of Fig. 13 or multi-column writer tool 40 of Fig. 14).

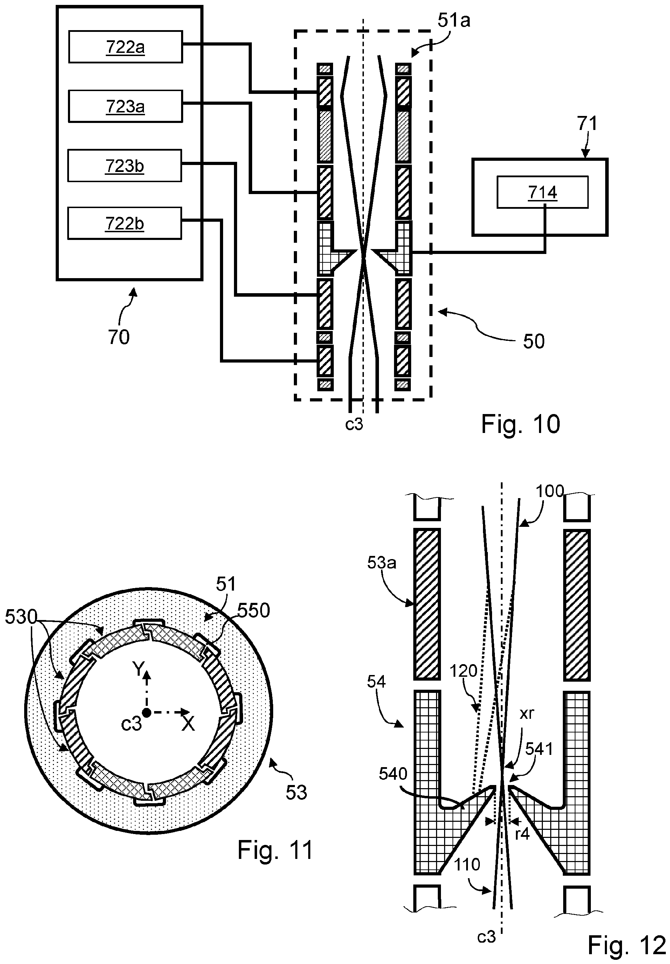

In typical embodiments the charged particle lens 10 may have exemplary dimensions of overall height h1 of about 50mm to 100mm and an inner height h2 of about 10mm to 100mm, typically smaller than the overall height h1, therefore enabling a design where an outermost yoke component 251, also referred to as outer yoke shell serves as a housing and shielding body for the lens assembly, and outer radius r1 of about 10mm to 20mm, enabling deployment in a multi-column writer tool 40 of Fig. 14, and an aperture radius r2 of about 0.1mm to 5mm, i.e. wide enough to enable a charged particle beam passage and may even allow for further inserts (see Fig. 10 below). Said magnets, gaps and electromagnetic adjustment assembly typically are about 1mm to 5mm thick, and the yoke components may have similar dimensions in radial thickness. The sizes of the components are chosen as suitable for the respective application and charged particle apparatus; in the shown embodiments the geometric dimensions are typically in the order of several millimeters.

The charged particle lens 10 is usually arranged in a particle beam exposure system in a way that its central axis cx coincides with the optical axis c5 of the exposure system (cf. Fig. 13); but the skilled person will appreciate that also other relative arrangements may be chosen depending on the application of the charged particle lenses according to the invention.

### Magnetic Circuits and Electromagnetic Adjustment Assembly

According to the invention, a magnetic circuit assembly 20 and the corresponding magnetic lenses include an electromagnetic adjustment assembly 30 comprising at least one electromagnetic adjustment coil 31 and components for electrical supply and control thereof. As mentioned, the electromagnetic adjustment coil serves to adjust the magnetic flux density in the yokes and in the yoke gaps 290, 291. The adjustment coil 31 will be driven by a current Io provided by the electric supply; the value of this current Io is adjusted, for instance, by monitoring the effect of the magnetic lens, for instance by measuring the imaging properties at the location of the target, and modifying the value of the current until a desired ("optimal") imaging effect is obtained.

A significant advantage of providing an electromagnetic adjustment coil according to the invention is the capability of in-situ adjustment of the magnetic flux in the magnetic circuit. Consequently, whenever there are changes to the magnetic properties of the magnetic lens assembly (like magnet aging), the invention offers to compensate such changes using the at least one electromagnetic adjustment coil.

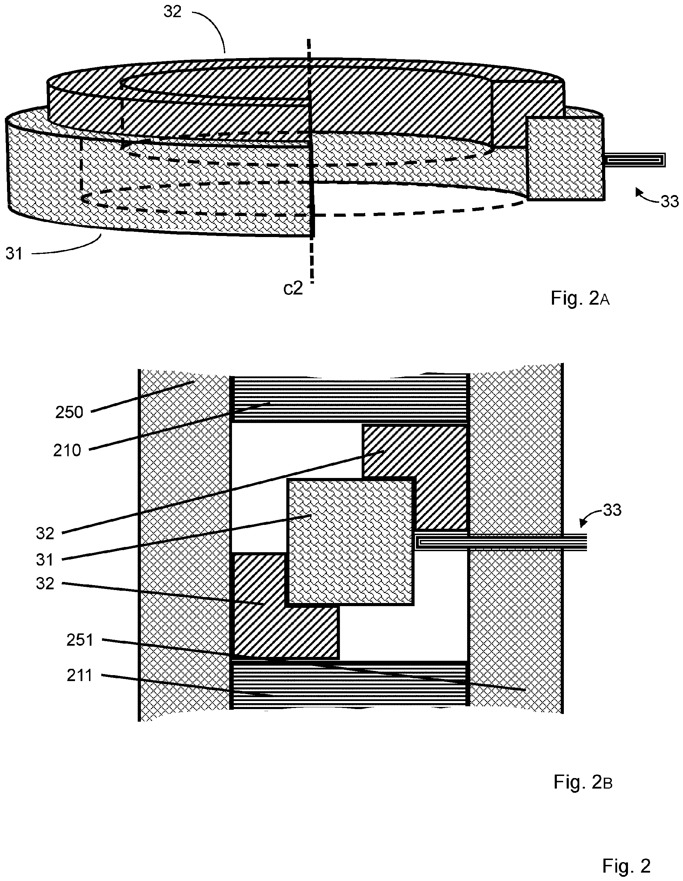

As illustrated in Figs. 2_{A} and 2_{B}, the electromagnetic adjustment coil 31 is supported by one or more dedicated holder devices 32 within the assembly. The electromagnetic adjustment coil 31 and its associated components (such as the holder devices) preferably have a basically symmetric ring shape with a common central axis c2, which will preferably coincide with the central axis cx of a lens assembly. The holder devices 32 are configured for positioning the component in a space between the yoke components. Only one holder device 32 is shown in Fig. 2A for better visibility of the electromagnetic adjustment coil.

In order to enable the creation of a magnetic flux, the electromagnetic adjustment coil 31 comprises an electrical circuit including a plurality of windings of electrically conductive material. This electrical circuit is electrically supplied by an electric current through electric lines within an electrically insulating interface 33 to the outside of the magnetic lens assembly, in order to connect to a power supply 34 of the electromagnetic adjustment assembly 30 (Fig. 1).

The interface 33 traverses the outer housing, i.e., the outer yoke shell 251. To achieve this, several holes may be drilled radially inward at different angular positions. It is important to take into account the effect of these holes on the yoke magnetic behavior, because a significantly asymmetric group of holes might induce asymmetric effects in the created magnetic field, which is usually undesired. For instance, a suitable configuration to deal with this problem can be providing a set of holes, for instance 16 holes, which are uniformly distributed around the circumference, while the size of the holes is as small as possible while fulfilling the required cross-section for the electric lines within the interface 33.

Conventional permanent magnetic lenses can reach an accuracy within 1% to 5% range of the targeted magnetic field strength, due to manufacturing ranges of the permanent magnets deployed in such systems. Using an electromagnetic adjustment assembly according to the invention it is possible to lower this range to accuracies within 0.1% to 0.5% around the targeted effects or even lower values, which provides deviations from the desired magnetic fields that are by an order of magnitude smaller and thus distinctly better performance.

The electromagnetic adjustment coil is typically placed in close vicinity of the two or more permanent magnets 210, 211 and between the yoke components 250, 251 (see Fig. 2B); where it may have to be deployed during the assembly of the lens, since the position is rather encapsulated; nevertheless, the electromagnetic adjustment coil could also be added after a first assembly, provided suitable technical solutions are used, e.g. partial disassembly, or the element being constructed of replaceable modules within the lens.

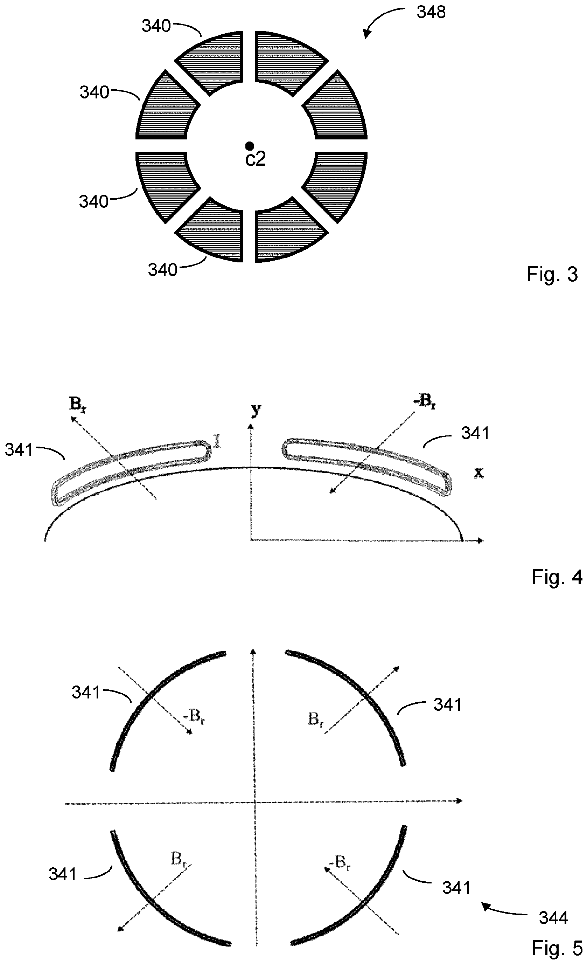

Referring to Figs. 3 to 5, in some embodiments of the invention a sectorial electromagnetic adjustment coil arrangement may be provided, which is composed of sub-components 340 arranged around a common axis c2, which may preferably coincide with the central axis cx of the lens assembly. Fig. 3 shows a schematic top view of one met of a sectorial coil arrangement 348 having eight sector-shaped sub-components 340. The sub-components are preferably realized as sectors 340, provided with respective sub-component windings forming closed loops with a winding axis pointing respectively radially outwards or inwards. By providing neighboring sub-component windings with currents in mutually opposite directions, the created B-fields are alternating between positive radial and negative radial direction. In Figs. 4 and 5, another embodiment of a sectorial coil arrangement 344 including a 4-sector arrangement is illustrated. As can be seen, the sector-shaped sub-components preferably can be operated so as to have different orientations of the magnetic field, for instance mutually opposite radial directions denoted Bᵣ and -Bᵣ, respectively. Fig. 4 is a perspective view of two sub-components 341 of the 4-sector arrangement, where a current I flows with opposite current directions as denoted with arrows along the winding path, and the resulting magnetic flux vectors, denoted Bᵣ and -Bᵣ respectively, pointing radially inwards and outwards in an alternating arrangement; Fig 5 shows the four sub-components 341 of the arrangement 344 in a top view. This 4-sector arrangement can be used to implement a magnetic quadrupole. Such an arrangement that includes sector components with different directions of magnetic flux realizes a magnetic multipole structure, which can be used to intentionally generate and/or compensate azimuthal variations; this may be used, for example, to counteract permanent magnets imposing multipole like features. On the other hand, selected regions may also be kept empty on purpose. The placement of such an arrangement with multiple sectors underlies the same rules as a circular electromagnetic adjustment coil and is discussed in the section below. The value of the current I driving the sectorial coils can be adjusted, for instance, in essentially the same manner as the current Io discussed above, i.e., by monitoring the effect of the magnetic lens, for instance by measuring the imaging properties at the location of the target, and modifying the value of the current until a desired ("optimal") imaging effect is obtained. Of course, in more elaborate embodiments also one or more magnetic sensors may be provided at suitable locations at the magnetic circuit, which may be used to establish a control loop and enable control of the magnetic flux and modifications thereof through suitable adjustment of the currents I₀, I.

In many embodiments a symmetric lens assembly is of special interest. Each magnetic field of a radially symmetric magnetic lens composition comprises an axial component and a radial component *B* = *Bᵣ* + *B_{z}* ; while the radial component *Bᵣ* is of little importance, the resulting axial component *B_{z}* of the magnetic field is exploited for the lens effect. The strength of the axial component of the magnetic field at the location of the central axis cx as a function of the longitudinal coordinate is depicted in Fig. 1B (solid line 61 indicating the "original" magnetic field, and dashed line 62 illustrating the modified/corrected field by virtue of the adjustment coil according to the invention); a typical value of the peak value of the axial magnetic field *B_{z}* is in the order of 0.1 T, in applications where the charged particles are electrons. As explained above a magnetic circuit will generate two regions near the gaps 290, 291 of (comparatively) high magnetic field intensity, which will act as two consecutive magnetic lenses with well-defined focal lengths and optical aberrations in the beam passage 11. Magnetic coupling of the two lenses via a common yoke body 25 strongly reduces the effect of magnetic stray fields in any other regions, which would otherwise be inevitably associated with permanent magnets in particle lenses of conventional layouts.

### Placement of the electromagnetic adjustment coil

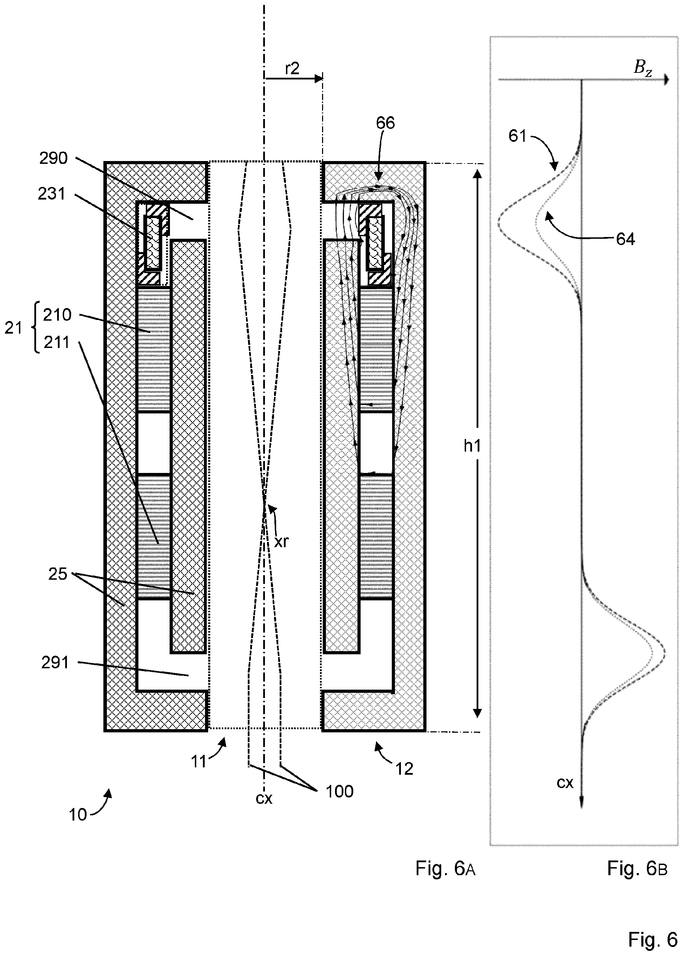

The placement of the electromagnetic adjustment coil according to the invention within the magnetic lens assembly may have an impactful role. For instance, as shown in Fig. 6_{A}, an electromagnetic adjustment coil 231 may be placed in a corner location surrounding the gap between the two yoke components, preferably close to one of the gaps 290, 291, in the example shown in the upper corner within the outer yoke shell. The magnetic field resulting from this electromagnetic adjustment coil 231, as it flows through the two yokes and the upper permanent magnet, is indicated as curve 64 in Fig. 6_{B}, which shows the axial magnetic flux density along the longitudinal axis cx. In an exemplary configuration, the upper permanent magnet may have a dominant magnetization in the radially outwards direction. The current polarity of the electromagnetic adjustment coil may be chosen in such a way that the created magnetic field acts against the permanent magnet's magnetization direction (see the magnetic field lines induced by the electromagnetic adjustment coil in the yokes and permanent magnets indicated with 66). This leads to a reduction of field strength in the upper gap 290 as indicated in Fig. 6_{B}. The dashed line 61 shows the unperturbed field created by the permanent magnet, whereas the dotted line 64 show a reduction in magnetic field strength induced by the electromagnetic adjustment coil. Furthermore, it can be seen that the adjustment field may also influence the flux and magnetic field strength in the lower magnetic lens, albeit to a smaller extent.

In another exemplary embodiment of this invention, illustrated in Fig. 1_{A}, an electromagnetic adjustment coil 31 may be placed centered along the longitudinal axis between two neighboring permanent magnets and radially between the two yokes. In such a configuration, the magnetic flux density created by the coil acts radially inwards at the location of one permanent magnet, and radially outwards at the other (symbolically indicated by magnetic field lines 65 in Fig. 1_{A}). It will, therefore, have an anti-symmetric tuning effect on the two lenses, as can be seen in the dotted curve 62 for the magnetic flux strength.

Furthermore, multiple electromagnetic adjustment coils may be combined in many suitable embodiments. For instance, coils in lens corners with dominant effects on one magnetic lens can be combined with coils located in gaps between two permanent magnets which create anti-symmetric effects. Such a configuration is shown in Fig. 9A where three electromagnetic adjustment coils 531, 532, 533 are provided at different positions along the axial axis. This can be used to induce localized changes of the two magnetic lenses and/or to counteract unintended intrinsic asymmetries of the magnets and/or yokes. In addition, for instance the central adjustment coil 532 comprises a sectorial coil, depicted symbolically by double rectangles at either side of Fig. 9A.

Each of the adjustment coils 31, 231, 531, 532, 533, mentioned above may be provided with, or replaced by, a sectorial coil, for instance of the type as discussed above with reference to Figs. 3 to 5.

### Permanent Magnets

The permanent magnets 210, 211 act as a source of the magnetic flux Φ in a magnetic circuit realized in the magnetic circuit assembly 20.

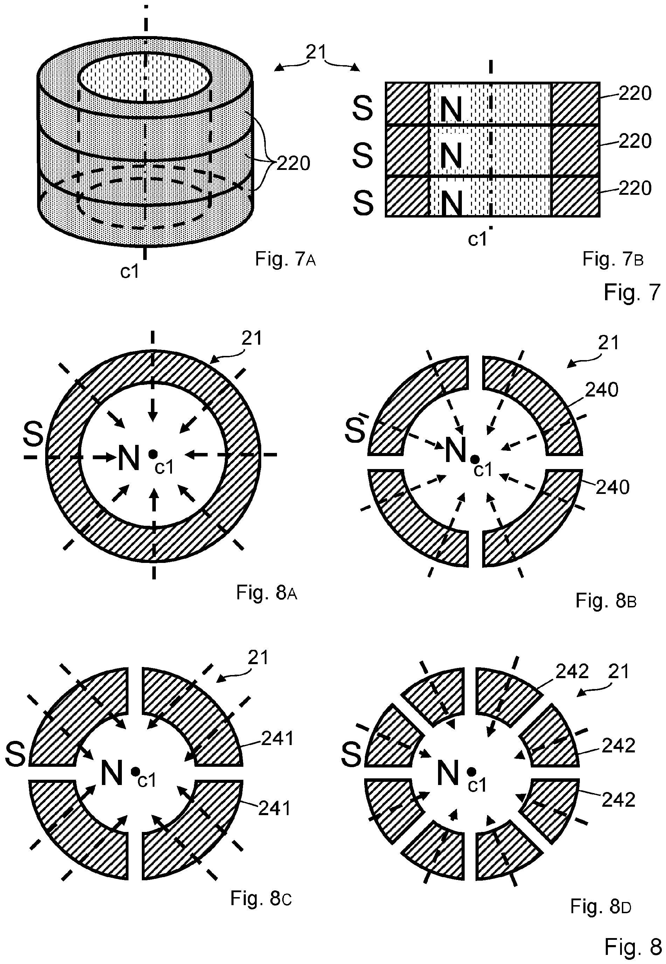

Fig. 7 illustrates one preferable embodiment of a permanent magnet 21 suitable for being used as a component of a magnetic circuit assembly of a lens according to the invention (e.g. as one of the permanent magnets 210, 211 of Fig. 1A). The magnet exhibits a primarily radial magnetization with a rotationally symmetric magnet. In Fig. 7, Fig.7A is a schematic perspective view, and Fig. 7B a schematic sectional view along the longitudinal axis c1 of the magnet 21.

In many embodiments and referring to Figs. 8_{A-D}, it may be useful that such magnets are composed of several sector parts. Figs. 8_{A-D} illustrate four exemplary variants of a ring magnet 21 having a net radial magnetization in respective schematic cross-sectional views, where the components of the ring magnet are shown exploded in Figs. 8_{A,B,C} for better clarity. This radial magnetization directions also yields the preferred positions of yoke components, i.e. inside and outside such ring magnets, picking up the flux from either pole of the magnet and directing it to the designed positions of the gaps 290, 291 between them (see Fig. 1A). Each of the magnet elements shall have said primarily radially oriented magnetization, as indicated by dashed arrows in Figs. 8_{A-D}, so as to have e.g. a "north" pole N formed towards the inner space of the ring magnet, whereas the outer sides have the "south" pole type S of the magnetization. Permanent magnet elements having radial magnetization as shown are commercially available, made of a ferromagnetic material such as sintered NdFeB, SmCo₅ or ferrite. The magnet elements 240, 241, 242 of the composite magnets of Figs. 8_{A-C} are joined by gluing or clamping or any other suitable means. The number of the magnet elements forming each ring magnet may be any number, such as one, two, three, four, six, or more, depending on the dimensions (in particular, height and radius) of the composit elements and the desired dimensions of the permanent magnet 21.

Furthermore, referring again to Fig. 7, in many embodiments the permanent magnet 21 may be realized as a ring-shaped component and comprise several layers of ring-shaped segment magnets 220 stacked along a common central axis c1. In such a segmented magnet, each layer or segment contributes a portion Φ_{220,*n*} to the total flux Φ₂₁ = Σ*ₙ* Φ_{220*,n*} of a magnet comprised of *n* layers.

### Housing Body

In many embodiments the yoke body 25 may also act as a housing 12 to the lens 10. The yoke body, comprised of an inner yoke component 250, which often and typically is realized as a hollow cylinder with an aperture radius r2 and of sufficient length h2 so that it exceeds at least the height of stacked permanent magnets and thermal control elements; and an outer yoke component 251, which may then also be realized having a cylindrically symmetric shape of height h1 with an aperture radius r2 and outer radius r1 wide enough to cover the thickness of each yoke component, and the magnets placed between them. Said outer yoke may advantageously have a double-"C"-shaped longitudinal cross section (Fig. 1A); in other words, the outer yoke comprises a central body portion shaped as a hollow cylinder, which may be concentric with a hollow cylinder of the inner yoke component, and furthermore having two end parts of disk-like shape with a central bore. Thus, the hollow space of the yoke components surrounds a beam passage 11 of radius r2 and height h1 along the longitudinal axis cx. The gaps 290, 291 of the magnetic circuit are provided between the axial outer end faces of the inner yoke component and the corresponding axial inner faces of the outer yoke component, which then represent respective pole-pieces of the magnetic circuit 20. The radial thickness of the hollow cylinders is typically, and without loss of generality, in the order of a few millimeters and the height of the assembly in order of a few tens of millimeters. The inner and outer yoke component now forming the housing body of the lens, by virtue of their shape, can enhance and concentrate the magnetic flux generated by the magnets. The outermost yoke component also acts as a shielding for the magnetic flux in radial and axial directions, since the special shape and materials will accumulate the flux within the dimensions of radius r1 and height h1.

### Electric Inlay

According to a further aspect of the invention as illustrated in Fig. 9, the charged particle lens 10 may beneficially comprise a sleeve insert or inlay 50, which is inserted into the beam passage 11 along the optical axis cx (Fig. 9A). Correspondingly, the physical dimensions of the inlay are appropriately chosen with respect to the dimensions discussed above, e.g. within a radius r2 and a height h1 of the lens. The inlay may comprise a number of beam control elements 52 - 54, including one or several electrically active elements that are employed to generate an adjustable electric field 65 (dashed line in Fig. 9_{B}) superposing the magnetic field 61 (solid line) in the beam passage. The strength of the electric field axial component E_{z} (i.e. along longitudinal direction) will have a typical value of peak value in the order of 10⁵ V/m.

In many embodiments of the inlay, the beam control elements 52 - 54 are generally ring-shaped components serving as electrically active elements, and they are stacked along the central axis c3 and oriented with their geometric axes concentric and parallel to the central axis cx of the lens. In many embodiments of the invention it is useful to have all control elements with a common inner radius r2; thus they define a passage opening 55 which transverses the lens and serves as a channel for the charged particle beam 100 during operation of the charged particle lens. Also, it can be useful to insert smaller aperture openings 54 for beam calibration (see below).

In the embodiment shown in Fig. 9A the beam control elements realize two Einzel lenses 52a, 52b, and two multipole electrodes 53a, 53b - all made of electrically conductive materials. For example, each of the multipole electrodes can be realized as a composite metallic ring, composed of multiple sections of equal arc length, for instance, and without loss of generality, 4, 6 or 8 sections, (see Fig. 11); their (radial) thickness is typically below 2 mm, and their lengths between 5 mm and 20 mm. In addition, preferably an electrically conductive ring-shaped aperture 54 is placed between the two multipoles 53a, 53b; this component is herein referred to as "calibration aperture". Electrically active elements may preferably be connected to their respective power supplies units 722a, 723a, 723a, 723b as shown in Fig. 10, so that their electrostatic potentials can be individually adjusted; in a variant, the power supplies may be combined in a common multi-channel power supply device 70 which provides the individual supply voltages. The calibration aperture may be controlled by the power supply device 70 or a separate dedicated electric control device 71. Finally, the electrically active elements are electrically separated from each other and terminated at both ends by elements referred to as field termination caps 51a, whose electric potential is denoted as "local ground", i.e. the point of reference. The field termination caps serve to confine the electric field to the passage space of the inlay; they thus provide a well-defined "field boundary" of the inlay towards surrounding components (such as other particle-optical columns 400, see Fig. 14). Some spaces on the inlays mounting body 51 between the field termination caps and other electrical elements can also be electrically insulating, e.g. realized as vacuum or a filler material using a non-conductive, preferably voltage-resistant, material such as ceramics.

In many embodiments of this invention the various elements 52 - 54 of the inlay 50 are supported and held together by a mounting body 51 of hollow-cylindrical shape (e.g. inner radius r3 and outer radius r2, with height h1) , which can be generally made of electrically insulating material such as e.g. ceramic or plastic; yet at least portions 51a facing the charged particle beam, may still be covered with electrically conductive materials and connected to a "drain", to avoid electrical charge-up. The electrode elements may be realized, for instance, as discrete ring-shaped elements 52a, 52b, 53a, 53b, 54 joined and held together within the body, or as conductive coatings 51a formed at the inner surface of the ring body, so as to have respectively limited shape and area.

With the inlay, the accuracy of optical properties, e.g. the focal length of a charged particle lens (which is limited in precision of manufacturing of permanent magnets, assembly accuracy and limitations in the adjustability with the at least one thermal control element) can reach a precision of 1ppm to 5ppm around the target value - thus an "ultra-high precision" tuning is feasible. Some embodiments of this invention may also include integrated corrections means, which can be used to overcome limitations, e.g. relating to aging effects of magnets, since electric fields can be adjusted and controlled with a precision in the ppm (parts-per-million) regime during the use of the lens without de-assembly, i.e. "in-situ tuning". In addition, the voltages of the beam control elements can be adjusted in combination with other optically and electrically active elements of the system, in order to change the property of the particle beam exposure apparatus 1, for example with respect to optical properties, e.g. aberrations, image planes etc.

Fig. 11 shows a cross-section of a multipole electrode of the inlay. The multipole electrode comprises a number of rods 530, which can be controlled with individual electric potentials by means of their respective external power supply units 70. Additionally, a global offset voltage may be applied to have them behave as additional electrostatic lenses. By virtue of the different voltages applied to the individual rods various field configurations of dipole, quadrupole or higher order electrostatic fields can be realized, with the purpose of shaping the particle beam crossing their corresponding transversal section of the optical axis. With respect to a typical application in the context of the embodiment of Figs. 10, the voltages applied to the rods are typically in the order of up to a few tens of volts. Such beam shaping can be used to compensate for errors due to imperfections of the optical system, such as magnetic inhomogeneities, mechanical manufacturing and/or assembly accuracies. In this respect, the multipoles can correct the beam position with respect to the optical axis c3 when used as dipoles, whose directions in the plane defined by the X and Y axes (Fig. 11) can be arbitrary if at least four different voltages +V1 (hatched rods to the right hand side), -V1 (hatched rods to the left hand side), +V2 (cross-hatched rods to the top), -V2 (cross-hatched rods to the bottom) are applied to the rods. Additionally, it is possible to compensate for astigmatism or other higher-order distortions by the multipoles when the latter are used as quadrupole or higher-order multipoles, by applying suitable voltages at the individual rods, in a manner similar to the dipole case.

It should be remarked that any multipole electrodes could also be used as (quasi-)static or as dynamic elements, i.e. having time-varying voltages, depending on the application. The skilled person will appreciate that the mentioned uses of beam control elements are mentioned as exemplary applications and not as restrictions on the functionalities that can be accomplished with the present invention.

Referring to Fig. 10 and Fig. 12, as already mentioned, in some embodiments of this invention the inlay 50 may include a passive element 54 referred to as "calibration aperture", which serves as a stopping component for deviating or deflected parts of the particle beam 120. Fig. 12 shows an enlarged detail of a longitudinal section of an example of the calibration aperture. The calibration aperture comprises a body 540 surrounding a calibration bore 541, which is an aperture of small radius r4 along the axis c3. The aperture serves to limit the size of the beam 100 traversing the charged particle lens by absorbing the parts 120 of the beam which travel outside of the aperture, and only a portion 110 can pass the aperture. In a preferred embodiment of the invention, one of the preceding inlay elements, for instance a multipole electrode 53a, enables varying the transversal location of the beam, with respect to the longitudinal axis, e.g. with a varying a voltage applied to selected electrodes of the multiple electrode forming an electric dipole field. A multipole can also be used for beam alignment. The charged particle lens 10 is advantageously configured so as to create a crossover xr at a position located at, or in the vicinity (e.g. 10 mm or less) of the longitudinal location of the calibration aperture 54. Thereafter, the beam diameter is smallest near said aperture.

In many embodiments of this invention, in particular in a particle beam apparatus used as a multi-beam writer tool, e.g. a single-column tool 1 or multi-column tool 40 (for the latter see below), the charged particle beam is split into a plurality of beamlets pb, which can selectively pass through the pattern-definition system 4, 43 without (e) or with (f) an additional transversal deflection (Fig. 12), introduced by said pattern-definition system. Such deflection is introduced in order to prevent the beamlets from reaching a target and hence define a discrete writing pattern. The deflected beamlets will reach an area on the body 540 of the "calibration aperture" beside the calibration bore 541, rather than traveling through it, and will thus be absorbed therein; the absorption of the beam 120 would cause generation of an electric charge-up in the element which may be eliminated, i.e. drained off, through the electric connection of the beam aperture, for instance towards a measuring device 714 which allows monitoring the amount of the beam absorbed (Fig. 10). The beamlets hitting the "calibration aperture" also induce a transfer of thermal energy onto it and, as a result, also to the surrounding inlay elements and finally the magnetic lens assembly. This has to be taken into account for the tuning of the magnetic lenses with the at least one thermal control element.

### Lithographic Apparatuses

Fig. 13 shows a schematic longitudinal sectional view of a single-column writer tool 1, which includes an exemplary embodiment of a lens of this invention; e.g. incorporating a charged particle lens according to one embodiment of the invention as an objective lens 10 in said tool. The writer tool employs a charged particle beam, which may be of electrons or ions (for instance ions of positive electric charge). A writer tool 1 comprises a vacuum housing 480 for the multi-column charged particle optics, a base 470 onto which the multi-column charged particle optics is mounted. On top of the base an X-Y stage 460, e.g. a laser-interferometer controlled air-bearing vacuum stage onto which a target 450, preferably an mask for lithographic purposes or silicon wafer in direct-writer tools, is mounted using a suitable handling system. The target may then be exposed with said charged particle beam of the writer, which e.g. comprise an resist layer.

The single-column optics of this embodiment preferably comprises a central axis c5, an illuminating system 3 including a charged particle source 7, a condenser 8 delivering a broad telecentric charged-particle beam ib to a pattern definition system 4 being adapted to let pass the beam only through a plurality of apertures defining the shape of sub-beams ("beamlets") permeating said apertures (beam shaping device), and a typically demagnifying and further energizing charged particle projection optics 5, composed of a number of consecutive charged particle lenses, which preferably include electrostatic and/or magnetic lenses, and possibly other particle-optical devices. In the embodiment shown in Fig. 13, the projection optics comprises e.g. a first charged particle lens 9, e.g. an electrostatic immersion lens, whereas a second lens 10, located downstream of the first lens, is realized using an charged particle lens according to an embodiment to this invention (e.g. Fig. 9A). Inside said charged particle lens 10 a "calibration aperture" 54 is realized as symbolically depicted; as described above, a portion of the beam (f), which was deflected by the pattern definition device 4, is absorbed, whilst other portions (e) will traverse the optical column unimpeded and expose a pattern onto the target 450.

A pattern definition device 4 serves to form the particle beam into a plurality of so-called beamlets which contain the information of the pattern to be transferred to the target. The structure, operation and data-handling of the pattern definition device 4 and its control device 404 are disclosed in US 9,443,699 and US 9,495,499 of the applicant, and the disclosure of those documents are herewith included by reference into the present disclosure.

Figs. 14_{A} and 14_{B} illustrate a multi-column writer tool 40 which includes, in each column, a respective instance of an exemplary embodiment of a lens of this invention; e.g. incorporating a charged particle lens according to one embodiment of the invention as an objective lens 10 in said tool. The writer tool employs a number of charged particle beams, which may be of electrons or ions (for instance ions of positive electric charge). As can be seen in Fig. 14_{A}, which shows a schematic longitudinal sectional view of the multi-column writer tool 40, the writer tool 40 comprises a vacuum housing 48 for the multi-column charged particle optics, a base 47 onto which the multi-column charged particle optics is mounted. On top of the base an X-Y stage 46, e.g. a laser-interferometer controlled air-bearing vacuum stage onto which a target 45, preferably an mask for lithographic purposes or silicon wafer in direct-writer tools, is mounted using a suitable handling system. The target may then be exposed with said charged particle beam of the writer, which e.g. comprise an resist layer.

The multi-column optics of this embodiment comprises a plurality of sub-columns 400 (the number of columns shown is reduced in the depiction for better clarity, and represent a much larger number of columns that are present in the multi-column apparatus in a realistic implementation). Preferably, the sub-columns have identical setups and are installed side-by-side with mutually parallel axes c5. Each sub-column has an illuminating system 42 including a charged particle source 41, delivering a broad telecentric charged-particle beam to a pattern definition system 43 being adapted to let pass the beam only through a plurality of apertures defining the shape of sub-beams ("beamlets") permeating said apertures (beam shaping device), and a typically demagnifying and further energizing charged particle projection optics 44, composed of a number of consecutive charged particle lenses, which preferably include electrostatic and/or magnetic lenses, and possibly other particle-optical devices. In the embodiment of Fig. 14, the projection optics comprises e.g. a first charged particle lens 44a, e.g. an electrostatic immersion lens, whereas a second lens 10, located downstream of the first lens, is realized using an charged particle lens according to an embodiment to this invention (e.g. Fig. 1A).

Fig. 14 shows, in a detail view, the lenses 10 used as second lens and their supporting components. Each second lens 10 of the sub-columns may be preferably mounted on a reference plate 49 which is mounted by suitable fastening means 49b onto the column base plate 47 or a specific flange 48 of the vacuum chamber. The reference plate 49 is fabricated from a suitable base material having low thermal expansion, such as a ceramic material based on silicon oxide or aluminum oxide, which has the advantage of little weight, high elasticity module and high thermal conductivity, and may suitably be covered with an electrically conductive coating, at least at its relevant parts, in order to avoid charging (by allowing electrostatic charges being drained off). It may also comprise apertures 49a coinciding with the beam passage 11 of the lenses 10 of each sub-column.

## Claims

1. A charged particle lens (10) configured to modify a charged-particle beam of a charged particle optical system (1), the lens being provided with a passage space (11) extending primarily along a longitudinal axis (cx) and allowing the passage of a charged-particle beam (100), said lens including a magnetic circuit assembly (20) comprising:
- at least one permanent magnet (21; 210, 211); and
- a yoke body (25; 250, 251);
said yoke body (25) being composed of at least two yoke components (250, 251), of which a first yoke component realizes an inner yoke shell (250), arranged surrounding the passage space (11), and a second yoke component realizes an outer yoke shell (251) which is arranged surrounding the inner yoke shell, said yoke components being arranged circumferential around the longitudinal axis (cx) and comprise highly magnetic permeable material;
said at least one permanent magnet (21) being arranged between the at least two yoke components and circumferentially around the inner yoke shell, said at least one permanent magnet comprising a permanent magnetic material (210, 211) being magnetically oriented with its two magnetic poles towards respective yoke components;
wherein in the magnetic circuit assembly (20), the at least one permanent magnet and the yoke body form a closed magnetic circuit but having at least two gaps (290, 291) formed between respective axial faces of different yoke components, configured to direct a magnetic flux density coming from said at least one permanent magnet through the yoke body and in said gaps induce a magnetic field (61), which is reaching inwards into the passage space,
the charged particle lens (10) including an electromagnetic adjustment coil (31) located between the inner and outer yoke shell (250, 251) and configured to be driven by an adjustable supply current, wherein the electric current in the electromagnetic adjustment coil (31) is substantially running along a circumferential direction around the longitudinal axis, the electromagnetic adjustment coil (31) being configured to modify the magnetic flux in the magnetic circuit to cause a variation in the magnetic flux density in at least one of the gaps (290, 291).

2. The charged particle lens of claim 1, further including an electromagnetic sectorial adjustment coil arrangement (348, 344) which comprises two or more sector coil elements, each sector coil element being realized with a general winding axis pointing in a respective radial direction, the sector coils of the sectorial adjustment coil being arranged in mutual circumferential angular offsets around the longitudinal axis (cx).

3. The charged particle lens of claim 1 or 2, wherein the electromagnetic adjustment coil (31), and optionally the sectorial adjustment coil arrangement, is configured to induce a redistribution of magnetic flux between two or more branches of the magnetic circuit, resulting in a change of the magnetic flux density in the at least two gaps (290, 291).

4. The charged particle lens of claim 1 or 2, wherein the electromagnetic adjustment coil (31), and optionally the sectorial adjustment coil arrangement, is configured to induce a modification of magnetic flux affecting mainly one of two or more branches of the magnetic circuit, resulting in a change of the magnetic flux density in a corresponding gap (290).

5. The charged particle lens of any one of the preceding claims, wherein two or more electromagnetic adjustment coils (31) are located at different locations associated with different components of the magnetic circuit assembly (20), configured to adjust the magnetic field in the two gaps (290, 291) differently.

6. The charged particle lens of any one of the preceding claims, wherein the electromagnetic adjustment coil (31), and optionally the sectorial adjustment coil arrangement, is provided with an electrical interface (33) to the outside of the charged particle lens, configured to supply the coil with electrical current, the electric interface preferably including a passageway formed in the outer yoke shell.

7. The charged particle lens of any one of the preceding claims, further comprising a holder component (32) configured to keep the electromagnetic adjustment coil (31) , and optionally the sectorial adjustment coil, in a defined position between the at least two components of the yoke body.

8. The charged particle lens of any one of the preceding claims, wherein the second yoke component (251) realizes a housing body (12) of said lens assembly, which surrounds the other components of the assembly including all other yoke components,
wherein preferably the at least one permanent magnet (21) has a magnetization oriented substantially radially.

9. The charged particle lens of any one of the preceding claims, wherein the at least one permanent magnet (21) is composed of at least two sub-components, namely:
- segmented according to two or more layers (220) stacked along a longitudinal axis (c1); and/or
- split into two or more sectors (240) arranged around a longitudinal axis (c1),
where preferably at least one thermal control device (31) is placed between respective two of said sub-components.

10. The charged particle lens of claim 1, having an overall rotationally symmetric shape along said longitudinal axis (cx), wherein the components of the magnetic circuit assembly (20), namely,
- the at least one permanent magnet (21); and
- the yoke body (25); as well as
the electromagnetic adjustment coil (31),
are arranged coaxial with said longitudinal axis and preferably have basic shapes corresponding to hollow cylinders or hollow polygonal prismatic shapes.

11. An electromagnetic lens including the charged-particle lens of any one of the preceding claims and a sleeve insert (50) inserted into the passage space (11) along the longitudinal axis (cx),
said sleeve insert (50) surrounding a beam passage (55) of radius (r3) smaller than the radius (r2) of the beam passage (11) of the charged-particle lens, extending along a longitudinal axis (c3), which preferably coincides with the longitudinal axis (cx) of the charged-particle lens,
said sleeve insert (50) comprising a mounting body (51), which is at least partially electrically conductive (51a), and at least one electrically conductive electrode element (52a, 53a, 52b, 53b),
said at least one electrode element being configured to be applied an electric potential via a power supplies (70) with respect to the potential of (51a) so as to generate an electrostatic field (65) within the beam passage,
wherein the electrode elements are configured to form a particle-optical lens in conjunction with the magnetic field (61) within the beam passage (55) at one or more of the gaps (290, 291), wherein a focal length of said charged particle-optical lens is adjustable through modifying the electric potentials applied to the electrode elements,
wherein preferably the inner yoke shell (250) extends along the longitudinal axis (c3) and surrounds the sleeve insert (50) circumferentially, and the at least two gaps (290, 291) of the magnetic circuit are located at either axial end of the inner yoke shell, each gap generating a defined magnetic field (61), reaching inwards into the beam passage opening (11, 55), said electrostatic field (65) generated by at least one of the electrode elements (52a, 53a, 52b, 53b) of the sleeve insert being configured to at least partially overlap with the magnetic field.

12. The electromagnetic lens of claim 11, wherein at least one of the electrode elements includes an electrostatic multipole electrode (53), comprising a number of sub-electrodes (530) arranged uniformly around the longitudinal axis (c3) along a circumferential direction, said electrodes being connectable to a multi-channel power supply unit (723) feeding potentials to each electrode individually.

13. The electromagnetic lens of claim 11 or 12, wherein the electrode elements include a beam aperture element (54) forming a delimiting opening (540) with a defined radius (r4) around the longitudinal axis (c3),
said delimiting opening being configured to limit the lateral width of a charged-particle beam (100) propagating along the longitudinal axis; and
said beam aperture element being connected to a current measurement device (71) configured to measure an amount of the charged-particle beam absorbed at the beam aperture element.

14. A charged-particle optical apparatus (1) including a charged particle lens or electromagnetic lens according to any one of the preceding claims and configured for influencing a charged-particle beam (e, f) of said apparatus propagating through the lens along the longitudinal axis (cx) thereof, wherein said lens is part of a particle-optic system (3, 5) of said apparatus.

15. The charged-particle optical apparatus of claim 14, wherein the apparatus is realized as a multi-column system (40) comprising a plurality of particle-optical columns, each column being configured to employ a respective particle beam and comprising a respective particle-optic system which includes a respective instance of a charged particle or electromagnetic lens.
